# EUROPEAN PATENT APPLICATION

(11) **EP 2 953 303 A1**
(43) Date of publication of application: **09.12.2015**
(21) Application number: 13877388.2
(22) Date of filing: 07.03.2013
(51) Int. Cl.: H04L 25/02

(54) **DATA COMPRESSION METHOD, AND REDUCTION METHOD, DEVICE AND SYSTEM**

(71) Applicant: Huawei Technologies Co., Ltd., Longgang District Shenzhen, Guangdong 518129 (CN)
(72) Inventor: QIN, Fengping, Shenzhen Guangdong 518129 (CN)
(74) Representative: Haley, Stephen
(86) International application number: PCT/CN2013/072267
(87) International publication number: WO 2014/134805

(57) **Abstract**

The present invention relates to a data compression method, a data restoration method, apparatuses, and a system. The data compression method includes: acquiring a first digital signal; acquiring a first compressed signal by performing down-sampling processing on the first digital signal, where a sampling frequency of the first compressed signal is not less than a frequency threshold, and the frequency threshold is twice a baseband cut-off frequency of the first digital signal; and sending the first compressed signal by using a transmission format based on the common public radio interface CPRI protocol. Frequency decrease is performed before data is transmitted by using the CPRI protocol, so as to reduce an amount of data to be transmitted by using a CPRI, and improve data transmission efficiency, or, in other words, increase a quantity of RRUs or BBUs that can be supported on per CPRI.

## Description

### TECHNICAL FIELD

The present invention relates to the communications field, and in particular, to a data compression method, a data restoration method, apparatuses, and a system.

### BACKGROUND

In a communications system, a great number of transmission resources need to be occupied when different devices transmit information between each other. For example, in a CDMA radio access network (CDMA Radio Access Network, C-RAN) architecture, a large amount of data needs to be transmitted between a radio remote unit (Radio Remote Unit, RRU) and a baseband unit (Baseband Unit, BBU) by using a common public radio interface (Common Public Radio Interface, CPRI), and many resources are consumed during fiber transmission, which increase hardware costs.

In the prior art, the foregoing problem is resolved mainly by performing, under the premise of no information loss, data compression processing on data to be transmitted. That is, before a signal output by an RRU is transmitted to a BBU, data is first compressed in a compression controller, differential coding and coding compression are performed on the compressed data and original data, and multiple data is multiplexed by using a multiplexer, is then transferred to the BBU by using the CPRI, and finally is decoded in the BBU, so as to restore a compressed signal. The compressed signal is sent to a baseband processor for subsequent processing. Coding methods mainly include: differential coding, Huffman coding, block floating-point coding, and the like. A main disadvantage of these methods is that: an amount of data to be transmitted by using the CPRI is still very large.

### SUMMARY

Embodiments of the present invention provide a data compression method, a data restoration method, apparatuses, and a system, which can reduce an amount of data to be transmitted.

According to a first aspect, an embodiment of the present invention provides a data compression method, including:
acquiring a first digital signal;
acquiring a first compressed signal by performing down-sampling processing on the first digital signal, where a sampling frequency of the first compressed signal is not less than a frequency threshold, and the frequency threshold is twice a baseband cut-off frequency of the first digital signal; and
sending the first compressed signal by using a transmission format based on the common public radio interface CPRI protocol.

With reference to the first aspect, in a first possible implementation manner, the down-sampling processing is performed on the first digital signal by means of interpolation and extraction.

With reference to the first aspect, in a second possible implementation manner, the first digital signal is a digital signal that is obtained by performing, by using a sampling frequency that is not less than a double chip rate, sampling on a filtered signal.

According to a second aspect, a data restoration method is provided, including:
receiving a first compressed signal that is in a transmission format based on the common public radio interface CPRI protocol, where the first compressed signal is obtained by performing down-sampling processing on a first digital signal, a sampling frequency of the first compressed signal is not less than a frequency threshold, and the frequency threshold is twice a baseband cut-off frequency of the first digital signal; and performing up-sampling processing on the first compressed signal, to obtain a second signal.

With reference to the second aspect, in a first possible implementation manner, the up-sampling processing is performed on the first compressed signal by means of interpolation and extraction.

With reference to the second aspect, in a second possible implementation manner, the first digital signal is a digital signal that is obtained by performing, by using a sampling frequency that is not less than a double chip rate, sampling on a filtered signal.

According to a third aspect, a data compression apparatus is provided, where the apparatus includes:
an acquiring unit, configured to acquire a first digital signal;
a processing unit, configured to acquire a first compressed signal by performing down-sampling processing on the first digital signal, where a sampling frequency of the first compressed signal is not less than a frequency threshold, and the frequency threshold is twice a baseband cut-off frequency of the first digital signal; and
a sending unit, configured to send the first compressed signal by using a transmission format based on the CPRI protocol.

With reference to the third aspect, in a first possible implementation manner, the processing unit performs the down-sampling processing on the first digital signal by means of interpolation and extraction.

With reference to the third aspect, in a second possible implementation manner, the first digital signal acquired by the acquiring unit is a digital signal that is obtained by performing, by using a sampling frequency that is not less than a double chip rate, sampling on a filtered signal.

According to a fourth aspect, a data restoration apparatus is provided, where the apparatus includes:
an acquiring unit, configured to receive a first compressed signal that is in a transmission format based on the common public radio interface CPRI protocol, where the first compressed signal is obtained by performing down-sampling processing on a first digital signal, a sampling frequency of the first compressed signal is not less than a frequency threshold, and the frequency threshold is twice a baseband cut-off frequency of the first digital signal; and
a processing unit, configured to perform up-sampling processing on the first compressed signal received by the acquiring unit, to obtain a second signal.

With reference to the fourth aspect, in a first possible implementation manner, the processing unit performs the up-sampling processing on the first digital compressed signal by means of interpolation and extraction.

With reference to the fourth aspect, in a second possible implementation manner, the first digital signal is a digital signal that is obtained by performing, by using a sampling frequency that is not less than a double chip rate, sampling on a filtered signal.

According to a fifth aspect, an embodiment of the present invention provides a radio remote unit RRU, including the data compression apparatus provided by the third aspect.

With reference to the fifth aspect, in a first possible implementation manner, the RRU further includes the data restoration apparatus provided by the fourth aspect.

According to a sixth aspect, an embodiment of the present invention provides a baseband unit BBU, including the data compression apparatus provided by the third aspect.

With reference to the sixth aspect, in a first possible implementation manner, the BBU further includes the data restoration apparatus provided by the fourth aspect.

According to a seventh aspect, an embodiment of the present invention provides a data compression apparatus, where the apparatus includes:
a processor;
a memory; and
a system bus, where
the system bus is configured to connect the processor and the memory; and
an application program is stored in the memory, where the application program includes an instruction that can be used for instructing the processor to execute the following processes:
   acquiring a first digital signal;
   acquiring a first compressed signal by performing down-sampling processing on the first digital signal, where a sampling frequency of the first compressed signal is not less than a frequency threshold, and the frequency threshold is twice a baseband cut-off frequency of the first digital signal; and
   sending the first compressed signal by using a transmission format based on the CPRI protocol.

With reference to the seventh aspect, in a first possible implementation manner, the down-sampling processing is performed on the first digital signal by means of interpolation and extraction.

With reference to the seventh aspect, in a second possible implementation manner, the first digital signal is a digital signal that is obtained by performing, by using a sampling frequency that is not less than a double chip rate, sampling on a filtered signal.

According to an eighth aspect, an embodiment of the present invention provides a data restoration apparatus, where the apparatus includes:
a processor;
a memory; and
a system bus, where
the system bus is configured to connect the processor and the memory; and
an application program is stored in the memory, where the application program includes an instruction that can be used for instructing the processor and the system to execute the following processes:
   receiving, by using a CPRI, a first compressed signal obtained by means of down-sampling, where a sampling frequency of the first compressed signal is not less than a frequency threshold, and the frequency threshold is twice a baseband cut-off frequency of a first digital signal; and
   performing up-sampling processing on the first compressed signal, to obtain a second signal.

With reference to the eighth aspect, in a first possible implementation manner, the up-sampling processing is performed on the first compressed signal by means of interpolation and extraction.

With reference to the eighth aspect, in a second possible implementation manner, the first digital signal is a digital signal that is obtained by performing, by using a sampling frequency that is not less than a double chip rate, sampling on a filtered signal.

According to a ninth aspect, an embodiment of the present invention provides a data transmission system, including the data compression apparatus provided by the third aspect or the seventh aspect.

With reference to the ninth aspect, in a first possible implementation manner, the system further includes the data restoration apparatus provided by the fourth aspect or the eighth aspect.

In the embodiments of the present invention, a first digital signal is acquired; down-sampling processing is performed on the first digital signal, to acquire a first compressed signal, where a sampling frequency of the first compressed signal is not less than a frequency threshold, and the frequency threshold is twice a baseband cut-off frequency of the first digital signal. The first compressed signal is sent in a transmission format based on the common public radio interface CPRI protocol, so as to reduce an amount of data to be transmitted by using a CPRI, and improve data transmission efficiency, or, in other words, increase a quantity of RRUs or BBUs that can be supported on per CPRI.

### BRIEF DESCRIPTION OF DRAWINGS

FIG. 1 is a schematic diagram of application scenarios of a data compression method and a data restoration method according to embodiments of the present invention;
FIG. 2 is a flowchart of a data compression method according to Embodiment 1 of the present invention;
FIG. 3 is a flowchart of a data restoration method according to Embodiment 2 of the present invention;
FIG. 4 is a schematic diagram of a data compression apparatus according to Embodiment 3 of the present invention;
FIG. 5 is a schematic diagram of a data restoration apparatus according to Embodiment 4 of the present invention;
FIG. 6 is a schematic diagram of a data compression apparatus according to Embodiment 5 of the present invention; and
FIG. 7 is a schematic diagram of a data restoration apparatus according to Embodiment 6 of the present invention.

### DESCRIPTION OF EMBODIMENTS

The technical solutions of the present invention are further described in detail below with reference to accompanying drawings and embodiments.

In a Wideband Code Division Multiple Access (Wideband Code Division Multiple Access, WCDMA) system, a baseband chip rate at which a piece of user equipment (User Equipment, UE) sends to a base station and a baseband chip rate at which the base station sends to the UE are both 3.84 Mchip/s, that is, a maximum frequency bandwidth, in a frequency domain, of a sent signal is 3.84 MHz, and a cut-off frequency thereof is 1.92 MHz. To prevent intersymbol interference from occurring during transmission, a baseband signal is usually filtered by a receive filter before the baseband signal is sent, so that a bandwidth of the baseband signal is extended to approximately 4.68 MHz, that is, after filtering of the receive filter, except the sent signal (which is referred to as a wanted signal), some redundant signals may also exist in signals to be transmitted, and the some redundant signals can achieve a function of preventing intersymbol interference from occurring during transmission. A cut-off frequency signal of a signal after extension is 2.34 MHz, and according to the Nyquist sampling theorem, a sampling frequency of a signal should be at least twice greater than a cut-off frequency of a wanted signal to ensure that aliasing of sampled signals is not generated, that is, all sampling frequencies should be at least twice 2.34 MHz. An antenna sends a received signal sent by a UE to an RRU, and after down-sampling, a down-sampled signal is transferred to a BBU by using a CPRI; or the BBU transmits, to the RRU by using the CPRI, a down-sampled signal that is to be sent to the UE, for being sent out.

With development of a base station towards a cloud radio access network (Cloud RAN), a BBU pool is formed by mass BBUs in a centralized manner, RRUs of multiple stations share resources of the BBU pool, the BBU pool is comprised of multiple BBUs, a connection manner between the RRU and the BBU is the same as a connection manner between the RRU and one BBU in the BBU pool, and this embodiment uses the BBU as an example for description.

In this process, to facilitate implementation, all sampling frequencies of signals transmitted between the BBU and the RRU are 7.68 MHz, that is, a sampling frequency of a signal is usually twice 3.84 MHz, namely, 7.68 MHZ. Using 7.68 MHZ is because it can facilitate, on hardware, synchronization and timing on digital signal processing. However, as a quantity of users increases, the quantity of more users needs to be transmitted by using the CPRI. To achieve such an objective, it may be implemented by reducing an amount of data, which is to be transmitted by using the CPRI, of each user, and therefore, it is considered that a sampling frequency of a signal transmitted by using the CPRI is reduced based on no loss of a wanted signal. Under the premise of no signal loss, the sampling frequency may be reduced from 7.84 MHz to 4.68 MHz, and if certain information loss is allowed, the sampling frequency may be further reduced. That is, a sampling rate multiple x (x is a multiple of an actual sampling frequency relative to 3.84 MHz) meets a condition: 3.84*x* ≥ 4.68, and it can be known that *x* ≥ 4.68/3.84.

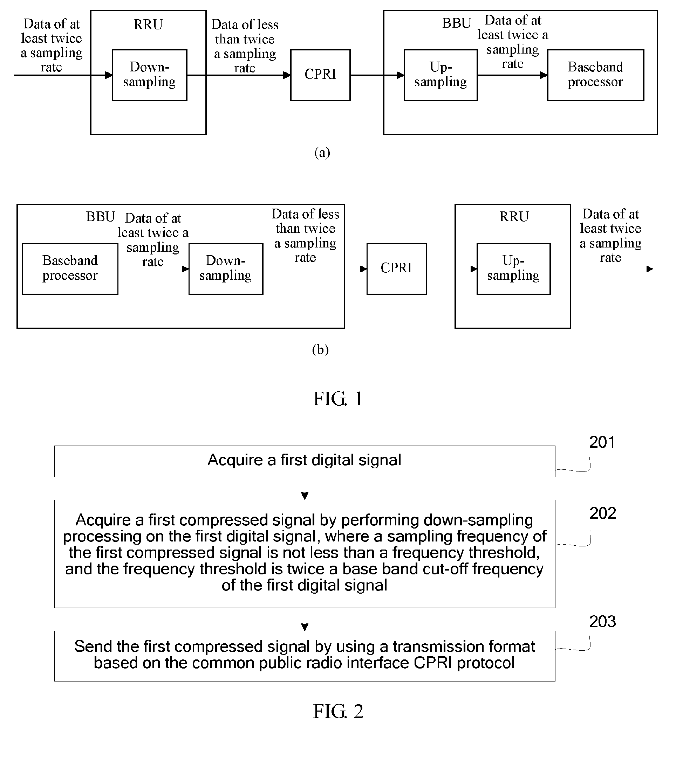

FIG. 1 is a schematic diagram of application scenarios of a data compression method, a data restoration method, apparatuses, and a system according to embodiments of the present invention. As shown in FIG. 1, down-sampling compression is performed on a signal that is transmitted between an RRU and a BBU by using a CPRI, a sampling frequency of the signal is reduced to x times (*x* ≥ 4.68/3.84), and the signal is then transmitted by using the CPRI protocol, which is specifically: in FIG. (a), a process of down-sampling is performed in the RRU, data of at least twice (a multiple relative to 3.84 MHz) a sampling rate is reduced to data of x times the sampling rate by means of frequency decrease, then the data is transmitted by using the CPRI protocol, up-sampling is performed after the BBU receives the data, to restore the data to the data of at least twice the sampling rate, and then the restored data is sent to a baseband processor for subsequent processing. In FIG. (b), a process of down-sampling is performed in the BBU, a signal output by the baseband processor in the BBU is data of at least twice a sampling rate, the data of at least twice the sampling rate is down-sampled to data of x times the sampling rate, then the data is transmitted by using the CPRI protocol, and up-sampling is performed on the data after RRU receives the data, to restore the data to the data of at least twice the sampling rate. As can be seen, in both the foregoing two processes, down-sampling is performed on data before transmission, so as to reduce an amount of data to be transmitted by using a CPRI, and improve data transmission efficiency, or, in other words, increase a quantity of RRUs or BBUs that can be supported on per CPRI.

A procedure of a data compression method is described in the following embodiment. FIG. 2 is a flowchart of a data compression method according to Embodiment 1 of the present invention. As shown in FIG. 2, the method provided by this embodiment of the present invention includes:

S201. Acquire a first digital signal.

The first digital signal is a digital signal that is obtained by performing, by using a sampling frequency that is not less than a double chip rate, sampling on a filtered signal.

In an existing WCDMA system, a baseband chip rate at which a UE sends to a base station and a baseband chip rate at which the base station sends to the UE are both 3.84 Mchip/s, that is, a maximum frequency bandwidth, in a frequency domain, of a sent signal is 3.84 MHz. To prevent intersymbol interference from occurring during transmission, a baseband signal is usually filtered by a receive filter before the baseband signal is sent, so that a bandwidth of the baseband signal is extended to approximately 4.68 MHz. The signal filtered by the receive filter herein becomes a filtered signal, the signal obtained by sampling the filtered signal is referred to as the first digital signal, a sampling frequency of the first digital signal generally is not less than 7.68 MHz, and 7.68 MHz is usually used to facilitate hardware implementation.

S202. Acquire a first compressed signal by performing down-sampling processing on the first digital signal, where a sampling frequency of the first compressed signal is not less than a frequency threshold, and the frequency threshold is twice a baseband cut-off frequency of the first digital signal.

Specifically, according to the Nyquist sampling theorem, a sampling frequency of a signal should be at least twice greater than an original cut-off frequency of the signal to ensure that aliasing of sampled signals is not generated. Therefore, when the down-sampling processing is performed on the first digital signal, frequency decrease cannot be performed unlimitedly, but it needs to ensure that the sampling frequency is at least twice the baseband cut-off frequency of the first digital signal, that is, a frequency threshold may be set, and the frequency threshold is twice the baseband cut-off frequency of the first digital signal. That is, if the baseband cut-off frequency of the first digital signal is 2.34 MHz, a down-sampling frequency must be greater than 4.68 MHz.

Specifically, the down-sampling processing may be performed on the first digital signal by means of interpolation and extraction. How to perform down-sampling by means of the interpolation and extraction is an existing mature technology, which is not described in detail herein again. According to the present invention, a sampling rate is reduced by using a method of performing interpolation and extraction on a digital signal, so as to achieve an objective of data compression, and avoid a problem of a high bit error rate that is brought by a method for implementing data compression by coding data. As can be seen, because the data is not compressed by using a compression controller, resource consumption is reduced, and because the data is not coded by using differential coding, Huffman coding, block floating-point coding, and the like, occurrence of out-of-synchronization of data can be avoided during subsequent data restoration, so as to avoid a high bit error rate.

It should be noted that, under the premise of no signal loss, the sampling frequency may be any value between 7.84 MHz to 4.68 MHz. If certain information loss is allowed, the sampling frequency may be lower than 4.68 MHZ.

S203. Send the first compressed signal by using a transmission format based on the common public radio interface CPRI protocol.

Data after frequency decrease is sent in the transmission format of the CPRI protocol, so that an amount of data to be transmitted can be reduced, and resources can be saved.

It should be noted that, the data compression method provided by this embodiment of the present invention not only can be applied to the BBU, but also can be applied to the RRU, and may also be applied to another related system in this field.

The foregoing embodiment is described as that: a first digital signal is acquired; down-sampling processing is performed on the first digital signal, to acquire a first compressed signal. The first compressed signal is sent in a transmission format based on the common public radio interface CPRI protocol. Frequency decrease is performed before data is transmitted by using the CPRI protocol, so as to reduce an amount of data to be transmitted by using a CPRI, and improve data transmission efficiency, or, in other words, increase a quantity of RRUs or BBUs that can be supported on per CPRI.

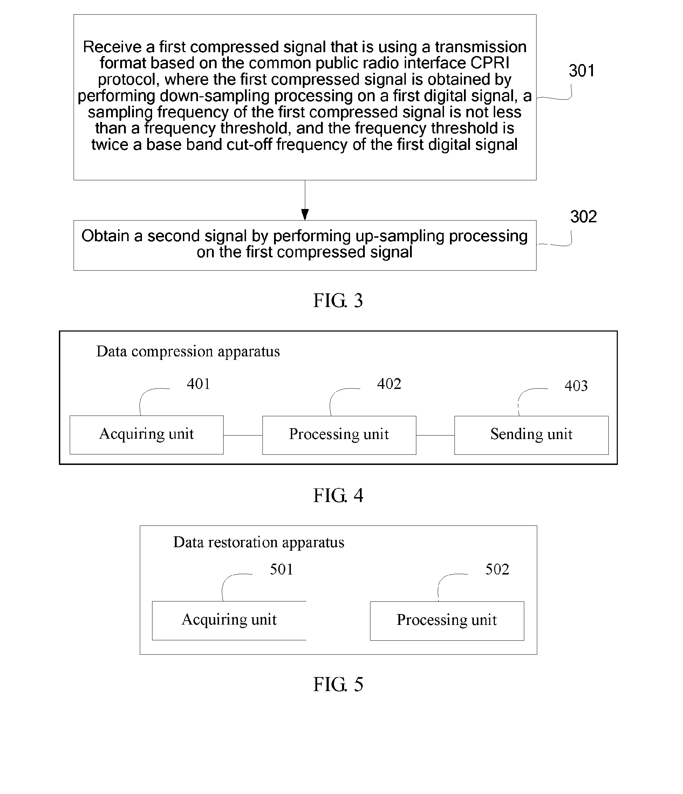

Correspondingly, an embodiment of the present invention provides a data restoration method. FIG. 3 is a flowchart of a data restoration method according to Embodiment 2 of the present invention. As shown in FIG. 3, the method provided by this embodiment of the present invention includes:

S301. Receive a first compressed signal that is sent in a transmission format based on the common public radio interface CPRI protocol, where the first compressed signal is obtained by performing down-sampling processing on a first digital signal, a sampling frequency of the first compressed signal is not less than a frequency threshold, and the frequency threshold is twice a baseband cut-off frequency of the first digital signal.

The first digital signal is a digital signal that is obtained by performing sampling by using a sampling frequency that is not less than a double chip rate.

Specifically, a BBU (or an RRU) receives, by using a CPRI, a first compressed signal sent by the RRU (or the BBU), where the first compressed signal is a compressed signal after frequency decrease processing, and a sampling frequency of the first compressed signal meets the Nyquist sampling theorem, that is, the sampling frequency of the first compressed signal is at least twice the baseband cut-off frequency of the first digital signal, that is, if the baseband cut-off frequency of the first digital signal is 2.34 MHz, a down-sampling frequency must be greater than 3.68 MHz, so as to ensure that the first compressed signal can be restored in a next step.

S302. Perform up-sampling processing on the first compressed signal, to obtain a second signal. The second signal may be the first digital signal, or may be a signal different from the first digital signal.

Specifically, the up-sampling processing may be performed on the first compressed signal by means of interpolation and extraction, and the first compressed signal can be restored to a state before down-sampling. The sampling frequency of the first digital signal generally is not less than 7.68 MHz, and is usually 7.68 MHz to facilitate subsequent hardware processing. It should be noted that, the data compression method provided by this embodiment of the present invention not only can be applied to the BBU, but also can be applied to the RRU, and may also be applied to another related system in this field. As can be seen, because a relationship between former and latter data does not need to depend on when the signal is being restored, out-of-synchronization of data does not occur, so as to avoid a high bit error rate.

The foregoing embodiment is described as that: a first compressed signal obtained by means of down-sampling is received by using a CPRI; and up-sampling processing is performed on the first compressed signal, to obtain a second signal. Because the first compressed signal received by using the CPRI can be restored to a state before down-sampling of the first compressed signal, for subsequent processing, so as to reduce an amount of data to be transmitted by using the CPRI, and improve data transmission efficiency, or, in other words, increase a quantity of RRUs or BBUs that can be supported on per CPRI.

Correspondingly, an embodiment of the present invention provides a data compression apparatus corresponding to the data compression method. FIG. 4 is a schematic diagram of a data compression apparatus according to Embodiment 3 of the present invention. As shown in FIG. 4, the apparatus provided by this embodiment of the present invention includes: an acquiring unit 401, a processing unit 402, and a sending unit 403.

The acquiring unit 401 is configured to acquire a first digital signal.

The processing unit 402 is configured to acquire a first compressed signal by performing down-sampling processing on the first digital signal, where a sampling frequency of the first compressed signal is not less than a frequency threshold, and the frequency threshold is twice a baseband cut-off frequency of the first digital signal.

The sending unit 403 is configured to send the first compressed signal by using a transmission format based on the CPRI protocol.

The first digital signal acquired by the acquiring unit 401 is a digital signal that is obtained by performing, by using a sampling frequency that is not less than a double chip rate, sampling on a filtered signal.

The processing unit 402 performs the down-sampling processing on the first digital signal by means of interpolation and extraction.

It should be noted that, the data compression method provided by the foregoing Embodiment 1 is embedded in the apparatus provided by this embodiment of the present invention; therefore, a specific working process of the apparatus provided by this embodiment of the present invention is not described in detail herein again.

The foregoing embodiment is described as that: the acquiring unit 401 acquires a first digital signal; the processing unit 402 performs down-sampling processing on the first digital signal, to obtain a first compressed signal; and the sending unit 403 sends the first compressed signal by using a transmission format based on the CPRI protocol. Frequency decrease is performed before data is transmitted by using the CPRI protocol, so as to reduce an amount of data to be transmitted by using a CPRI, and improve data transmission efficiency, or, in other words, increase a quantity of RRUs or BBUs that can be supported on per CPRI.

Correspondingly, an embodiment of the present invention provides a data restoration apparatus corresponding to the data restoration method. FIG. 5 is a schematic diagram of a data restoration apparatus according to Embodiment 4 of the present invention. As shown in FIG. 5, the apparatus provided by this embodiment of the present invention includes: an acquiring unit 501 and a processing unit 502.

The acquiring unit 501 is configured to receive a first compressed signal that is sent in a transmission format based on the common public radio interface CPRI protocol, where the first compressed signal is obtained by performing down-sampling processing on a first digital signal, a sampling frequency of the first compressed signal is not less than a frequency threshold, and the frequency threshold is twice a baseband cut-off frequency of the first digital signal.

The processing unit 502 is configured to perform up-sampling processing on the first compressed signal received by the acquiring unit 501, to obtain a second signal.

The processing unit 502 performs the up-sampling processing on the first digital compressed signal by means of interpolation and extraction.

It should be noted that, the data restoration method provided by the foregoing Embodiment 2 is embedded in the apparatus provided by this embodiment of the present invention; therefore, a specific working process of the apparatus provided by this embodiment of the present invention is not described in detail herein again.

The foregoing embodiment is described as that: the acquiring unit 501 receives, by using a CPRI, a first compressed signal obtained by means of down-sampling; and the processing unit 502 performs up-sampling processing on the first compressed signal received by the acquiring unit 501, to obtain a second signal. Because the first compressed signal received by using the CPRI can be restored to a state before down-sampling of the first compressed signal, for subsequent processing, so as to reduce a amount of data to be transmitted by using the CPRI, and improve data transmission efficiency, or, in other words, increase a quantity of RRUs or BBUs that can be supported on per CPRI.

Correspondingly, an embodiment of the present invention further provides a radio remote unit RRU, including the data compression apparatus in the foregoing Embodiment 3 or/and the data restoration apparatus in the foregoing Embodiment 4.

Correspondingly, an embodiment of the present invention provides a baseband unit BBU, including the data compression apparatus in the foregoing Embodiment 3 or/and the data restoration apparatus in the foregoing Embodiment 4.

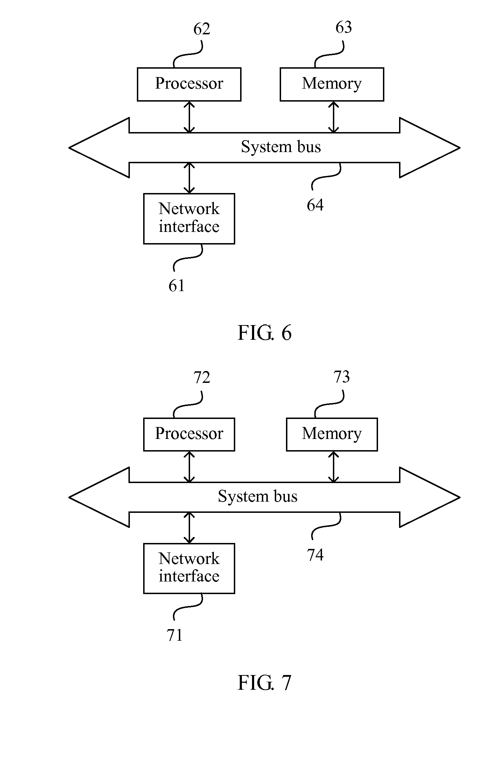

Correspondingly, an embodiment of the present invention provides another data compression apparatus corresponding to the data compression method. FIG. 6 is a schematic diagram of a data compression apparatus according to Embodiment 5 of the present invention. As shown in FIG. 6, the apparatus provided by this embodiment of the present invention includes: a network interface 61, a processor 62, and a memory 63. A system bus 64 is configured to connect the network interface 61, the processor 62, and the memory 63.

The network interface 61 is configured to communicate with the data compression apparatus and another apparatus.

The memory 63 may be a permanent memory, for example, a hard disk drive and a flash memory, and the memory 63 has a software module and a device driver. The software module can execute various functional modules of the foregoing method of the present invention; and the device driver may be a network and interface driver.

When starting, these software components are loaded into the memory 63, and then are accessed by the processor 62 and execute the following instructions:
acquiring a first digital signal;
acquiring a first compressed signal by performing down-sampling processing on the first digital signal, where a sampling frequency of the first compressed signal is not less than a frequency threshold, and the frequency threshold is twice a baseband cut-off frequency of the first digital signal; and
sending the first compressed signal by using a transmission format based on the CPRI protocol.

The first digital signal is a digital signal that is obtained by performing sampling by using a sampling frequency that is not less than a double chip rate.

The network interface 61 is specifically the CPRI.

The down-sampling processing is performed on the first digital signal by means of interpolation and extraction.

The foregoing embodiment is described as that: a first digital signal is acquired; down-sampling processing is performed on the first digital signal, to acquire a first compressed signal. The first compressed signal is sent in a transmission format based on the CPRI protocol. Frequency decrease is performed before data is transmitted by using the CPRI protocol, so as to reduce an amount of data to be transmitted by using a CPRI, and improve data transmission efficiency, or, in other words, increase a quantity of RRUs or BBUs that can be supported on per CPRI.

Correspondingly, an embodiment of the present invention provides another data restoration apparatus corresponding to the data restoration method. FIG. 7 is a schematic diagram of a data restoration apparatus according to Embodiment 6 of the present invention. As shown in FIG. 7, the apparatus provided by this embodiment of the present invention includes: a network interface 71, a processor 72, and a memory 73. A system bus 74 is configured to connect the network interface 71, the processor 72, and the memory 73.

The network interface 71 is configured to communicate with the data restoration apparatus and another apparatus.

The memory 73 may be a permanent memory, for example, a hard disk drive and a flash memory, and the memory 73 has a software module and a device driver. The software module can execute various functional modules of the foregoing method of the present invention; and the device driver may be a network and interface driver.

When starting, these software components are loaded into the memory 73, and then are accessed by the processor 72 and execute the following instructions:
receiving, by using a CPRI, a first compressed signal obtained by means of down-sampling, where a sampling frequency of the first compressed signal is not less than a frequency threshold, and the frequency threshold is twice a baseband cut-off frequency of a first digital signal; and
performing up-sampling processing on the first compressed signal, to obtain a second signal.

The first digital signal is a digital signal that is obtained by performing sampling by using a sampling frequency that is not less than a double chip rate.

The network interface 71 is specifically the CPRI.

The up-sampling processing is performed on the first compressed signal by means of interpolation and extraction.

The foregoing embodiment is described as that: a first compressed signal obtained by means of down-sampling is received by using a CPRI; and up-sampling processing is performed on the first compressed signal, to obtain a second signal. Because the first compressed signal received by using the CPRI can be restored to a state before down-sampling of the first compressed signal, for subsequent processing, so as to reduce an amount of data to be transmitted by using the CPRI, and improve data transmission efficiency, or, in other words, increase a quantity of RRUs or BBUs that can be supported on per CPRI.

An embodiment of the present invention further provides a data transmission system, including the data compression apparatus in the foregoing Embodiment 3, or the data compression apparatus in the foregoing Embodiment 5.

The system further includes the data restoration apparatus in the foregoing Embodiment 4, or the data restoration apparatus in the foregoing Embodiment 6.

A person skilled in the art may be further aware that, in combination with the examples described in the embodiments disclosed in this specification, units and algorithm steps may be implemented by electronic hardware, computer software, or a combination thereof. To clearly describe the interchangeability between the hardware and the software, the foregoing has generally described compositions and steps of each example according to functions. Whether the functions are performed by hardware or software depends on particular applications and design constraint conditions of the technical solutions. A person skilled in the art may use different apparatuses to implement the described functions for each particular application, but it should not be considered that the implementation goes beyond the scope of the present invention.

Steps of apparatuses or algorithms described in the embodiments disclosed in this specification may be implemented by hardware, a software module executed by a processor, or a combination thereof. The software module may be placed in a random access memory (RAM), a memory, a read-only memory (ROM), an electrically programmable ROM, an electrically erasable programmable ROM, a register, a hard disk, a removable disk, a CD-ROM, or a storage medium in any other form well-known in the art.

In the foregoing specific implementation manners, the objective, technical solutions, and beneficial effects of the present invention are further described in detail. It should be understood that the foregoing descriptions are merely specific implementation manners of the present invention, but are not intended to limit the protection scope of the present invention. Any modification, equivalent replacement, or improvement made without departing from the spirit and principle of the present invention shall fall within the protection scope of the present invention.

## Claims

1. A data compression method, wherein the method comprises:
acquiring a first digital signal;
acquiring a first compressed signal by performing down-sampling processing on the first digital signal, wherein a sampling frequency of the first compressed signal is not less than a frequency threshold, and the frequency threshold is twice a baseband cut-off frequency of the first digital signal; and
sending the first compressed signal by using a transmission format based on a common public radio interface CPRI protocol.

2. The data compression method according to claim 1, wherein the down-sampling processing is performed on the first digital signal by means of interpolation and extraction.

3. The data compression method according to claim 1, wherein the first digital signal is a digital signal that is obtained by performing, by using a sampling frequency that is not less than a double chip rate, sampling on a filtered signal.

4. A data restoration method, wherein the method comprises:
receiving a first compressed signal that is sent in a transmission format based on a common public radio interface CPRI protocol, wherein the first compressed signal is obtained by performing down-sampling processing on a first digital signal, a sampling frequency of the first compressed signal is not less than a frequency threshold, and the frequency threshold is twice a baseband cut-off frequency of the first digital signal; and
obtaining a second signal by performing up-sampling processing on the first compressed signal.

5. The data restoration method according to claim 4, wherein the up-sampling processing is performed on the first compressed signal by means of interpolation and extraction.

6. The data restoration method according to claim 4, wherein the first digital signal is a digital signal that is obtained by performing, by using a sampling frequency that is not less than a double chip rate, sampling on a filtered signal.

7. A data compression apparatus, wherein the apparatus comprises:
an acquiring unit, configured to acquire a first digital signal;
a processing unit, configured to acquire a first compressed signal by performing down-sampling processing on the first digital signal, wherein a sampling frequency of the first compressed signal is not less than a frequency threshold, and the frequency threshold is twice a baseband cut-off frequency of the first digital signal; and
a sending unit, configured to send the first compressed signal by using a transmission format based on a CPRI protocol.

8. The data compression apparatus according to claim 7, wherein the processing unit performs the down-sampling processing on the first digital signal by means of interpolation and extraction.

9. The data compression apparatus according to claim 7, wherein the first digital signal acquired by the acquiring unit is a digital signal that is obtained by performing, by using a sampling frequency that is not less than a double chip rate, sampling on a filtered signal.

10. A data restoration apparatus, wherein the apparatus comprises:
a acquiring unit, configured to receive a first compressed signal that is sent in a transmission format based on a common public radio interface CPRI protocol, wherein the first compressed signal is obtained by performing down-sampling processing on a first digital signal, a sampling frequency of the first compressed signal is not less than a frequency threshold, and the frequency threshold is twice a baseband cut-off frequency of the first digital signal; and
a processing unit, configured to perform up-sampling processing on the first compressed signal received by the acquiring unit, to obtain a second signal.

11. The data restoration apparatus according to claim 10, wherein the processing unit performs the up-sampling processing on the first compressed signal by means of interpolation and extraction.

12. The data restoration apparatus according to claim 10, wherein the first digital signal is a digital signal that is obtained by performing, by using a sampling frequency that is not less than a double chip rate, sampling on a filtered signal.

13. A radio remote unit RRU, comprising the data compression apparatus according to claim 7.

14. The RRU according to claim 13, further comprising the data restoration apparatus according to claim 10.

15. A baseband unit BBU, comprising the data compression apparatus according to claim 7.

16. The BBU according to claim 15, further comprising the data restoration apparatus according to claim 10.

17. A data compression apparatus, wherein the apparatus comprises:
a processor;
a memory; and
a system bus, wherein
the system bus is configured to connect the processor and the memory; and an application program is stored in the memory, wherein the application program comprises an instruction that can be used for instructing the processor to execute the following processes:
acquiring a first digital signal;
acquiring a first compressed signal by performing down-sampling processing on the first digital signal, wherein a sampling frequency of the first compressed signal is not less than a frequency threshold, and the frequency threshold is twice a baseband cut-off frequency of the first digital signal; and
sending the first compressed signal by using a transmission format based on the CPRI protocol.

18. The data compression apparatus according to claim 17, wherein the down-sampling processing is performed on the first digital signal by means of interpolation and extraction.

19. The data compression apparatus according to claim 17, wherein the first digital signal is a digital signal that is obtained by performing, by using a sampling frequency that is not less than a double chip rate, sampling on a filtered signal.

20. A data restoration apparatus, wherein the apparatus comprises:
a processor;
a memory; and
a system bus, wherein
the system bus is configured to connect the processor and the memory; and
an application program is stored in the memory, wherein the application program comprises an instruction that can be used for instructing the processor and the system to execute the following processes:
receiving, by using a CPRI, a first compressed signal obtained by means of down-sampling, wherein a sampling frequency of the first compressed signal is not less than a frequency threshold, and the frequency threshold is twice a baseband cut-off frequency of a first digital signal; and
performing up-sampling processing on the first compressed signal, to obtain a second signal.

21. The data restoration apparatus according to claim 20, wherein the up-sampling processing is performed on the first compressed signal by means of interpolation and extraction.

22. The data restoration apparatus according to claim 20, wherein the first digital signal is a digital signal that is obtained by performing, by using a sampling frequency that is not less than a double chip rate, sampling on a filtered signal.

23. A data transmission system, comprising the data compression apparatus according to claim 7 or claim 17.

24. The system according to claim 23, further comprising the data restoration apparatus according to claim 10 or claim 20.
